# EUROPEAN PATENT APPLICATION

(11) **EP 1 471 090 A1**
(43) Date of publication of application: **27.10.2004**
(21) Application number: 04252378.7
(22) Date of filing: 23.04.2004
(51) Int. Cl.: C08G 63/672

(54) **Polyester, its film and laminate**

(30) Priority: 24.04.2003 JP 2003120311
(71) Applicant: MITSUBISHI GAS CHEMICAL COMPANY, INC., Chiyoda-ku, Tokyo (JP)
(72) Inventor: Ohno, Daisuke, Tokyo Laboratory of Mitsubishi Gas, Katsushika-ku, Tokyo (JP); Ishii, Kenji, Tokyo Laboratory of Mitsubishi Gas, Katsushika-ku, Tokyo (JP); Norisue, Yasumasa, Tokyo Labaratory Mitsubishi Gas, Katsushika-ku, Tokyo (JP); Yanagida, Katsuhiko, Tokyo Lab. Mitsubishi Gas, Katsushika-ku, Tokyo (JP)
(74) Representative: Srinivasan, Ravi Chandran

(57) **Abstract**

A polyester having a specific structure in its skeleton which is obtained from, as a raw material, a bifunctional phenylene ether oligomer having a number average molecular weight of 500 to 3,000 and having a specific structure, a resin composition and a film made of the polyester, and a laminate using the above film.

## Description

### Field of the Invention

The present invention relates to a polyester obtained from a bifunctional phenylene ether oligomer having a specific structure as a raw material and to a film and a laminate made of the above polyester. The polyester of the present invention is a polymer material excellent in low dielectric characteristics and low moisture absorptivity and it may be used for wide applications such as an electrical insulating material, amoldingmaterial, a resin for a copper-clad laminate, a resin for a resist, a sealing resin for electronic parts, a resin for a color filter of liquid crystal, a coating composition, various coating agents, an adhesive, a buildup laminate material, a resin for a flexible substrate, a functional film, a fiber, a thermosetting resinmodifier and a thermoplastic resin modifier.

### Prior Arts of the Invention

Conventionally, polyester is widely used as a functional polymer material. In recent years, as higher performances are required in its application fields, physical properties required as a functional polymer material become severer increasingly. As such physical properties, for example, there are required heat resistance, weather resistance, chemical resistance, low moisture absorptivity, high fracture toughness, low dielectric constant, low dielectric loss tangent, moldability, transparency and flexibility. In a printed circuit board material field, for example, a substrate material having low dielectric characteristics is desired from a signal fade problem attendant upon an increase in the frequency of a signal. In a rigid substrate field, there are some attempts to use a liquid crystal polyester nonwoven fabric in place of a conventional glass fiber for attaining lower dielectric characteristics (for example, JP-A-2000-096410 (pages 1 to 8), JP-A-2002-064254 (pages 1 to 9)). In a flexible substrate field, further, a material having lower dielectric characteristics than a conventional polyimide and a material excellent in processability are required and some studies using a polyester film have been carried out (for example, JP-A-5-043664 (pages 1 to 6)).

### Summary of the Invention

It is an object of the present invention to provide a polyester having a low dielectric constant, a low dielectric loss tangent and a low moisture absorptivity and a film and a laminate using the above polyester.

The present invention relates to a polyester having a structure of the formula (5) which is obtained from a bifunctional phenylene ether oligomer having a specific structure of the formula (1) as a raw material and to a resin composition and a film made of the above polyester and a laminate obtained by laminating a metal foil on the above film.

According to the present invention, there is provided a polyester having a structure of the formula (5) which is obtained from, as a rawmaterial, a bifunctional phenylene ether oligomer having a number average molecular weight of 500 to 3,000 and having a specific structure of the formula (1), 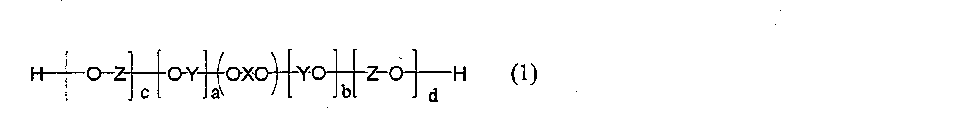 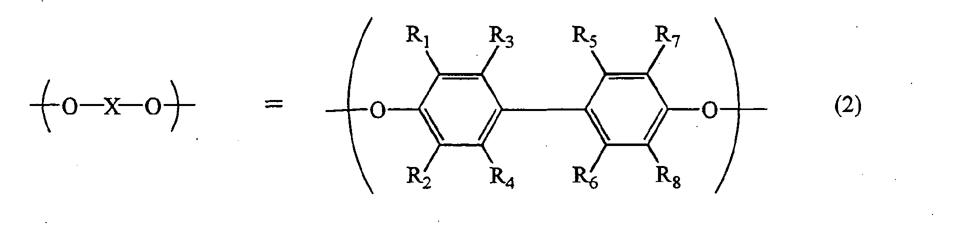 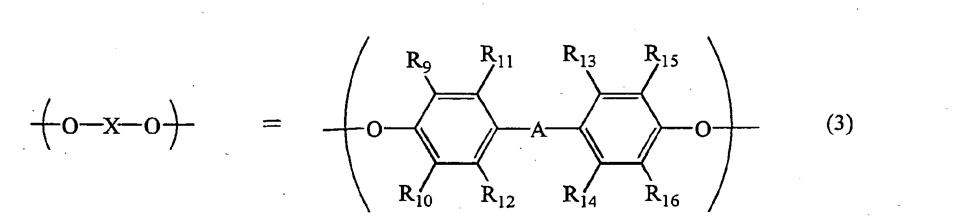 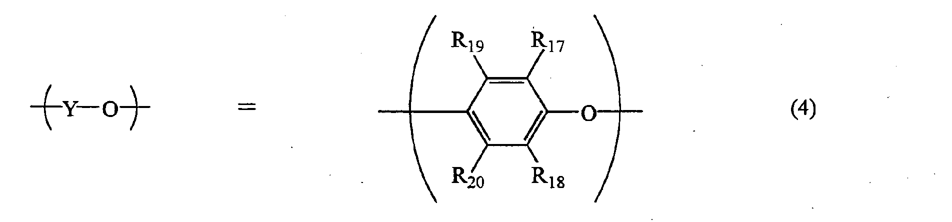 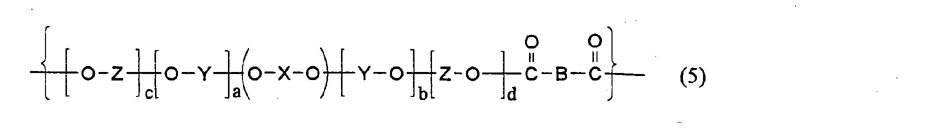 wherein - (O-X-O) - is composed of one kind of structure or at least two kinds of structures defined by the formula (2)
in which R₁, R₂, R₃, R₇ and R₈ may be the same or different and represent a halogen atom, an alkyl group having 6 or less carbon atoms or a phenyl group and R₄, R₅ and R₆ may be the same or different and represent a hydrogen atom, a halogen atom, an alkyl group having 6 or less carbon atoms or a phenyl group
and/or the formula (3)
in which R₉, R₁₀, R₁₅ and R₁₆ may be the same or different and represent a halogen atom, an alkyl group having 6 or less carbon atoms or a phenyl group and R₁₁, R₁₂, R₁₃ and R₁₄ may be the same or different and represent a hydrogen atom, a halogen atom, an alkyl group having 6 or less carbon atoms or a phenyl group,
A is a linear, branched or cyclic hydrocarbon having 20 or less carbon atoms,
- (Y-O)- is an arrangement of one kind of structure defined by the formula (4) or a random arrangement of at least two kinds of structures defined by the formula (4)
in which R₁₇ and R₁₈ may be the same or different and represent a halogen atom, an alkyl group having 6 or less carbon atoms or a phenyl group and R₁₉ and R₂₀ may be the same or different and represent a hydrogen atom, a halogen atom, an alkyl group having 6 or less carbon atoms or a phenyl group,
Z is an organic group having at least one carbon atom and may contain an oxygen atom, a nitrogen atom, a sulfur atom and/or a halogen atom,
B is a bivalent organic group and is formed of one kind of structure or at least two kinds of structures,
each of a and b is an integer of 0 to 30, provided that at least one of a and b is not 0, and
each of c and d is 0 or 1.

According to the present invention, further, there is provided a resin composition containing the above polyester.

According to the present invention, further, there is provided a film made of the above polyester.

According to the present invention, further, there is provided a film made of the above resin composition.

According to the present invention, further, there is provided a laminate comprising the above film, made of the above polyester, and metal foil(s) laminated on one surface or both surfaces of the film.

According to the present invention, further, there is provided a laminate comprising the film, made of the above resin composition, and metal foil (s) laminated on one surface or both surfaces of the film.

### Detailed Description of the Invention

The present inventors have made diligent studies and as a result found that a polyester, obtained from as a rawmaterial a bifunctional phenylene ether oligomer having the excellent dielectric characteristics and heat resistance of a polyphenylene ether structure, having a number average molecular weight of 500 to 3, 000 and having a specific structure, has excellent dielectric characteristics and a low moisture absorptivity and is soluble in a solvent. On the basis of the above finding, the present inventors have completed the present invention.

The present invention will be explained in detail hereinafter.

First, in the compound of the formula (1) , - (O-X-O) - is represented by the formula (2) or the formula (3). In the formula (2), R₁, R₂, R₃, R₇ and R₈ may be the same or different and represent a halogen atom, an alkyl group having 6 or less carbon atoms or a phenyl group and R₄, R₅ and R₆ may be the same or different and represent a hydrogen atom, a halogen atom, an alkyl group having 6 or less carbon atoms or a phenyl group. In the formula (3), R₉, R₁₀, R₁₅ and R₁₆ may be the same or different and represent a halogen atom, an alkyl group having 6 or less carbon atoms or a phenyl group and R₁₁, R₁₂, R₁₃ and R₁₄ may be the same or different and represent a hydrogen atom, a halogen atom, an alkyl group having 6 or less carbon atoms or a phenyl group.

A in the formula (1) is a linear, branched or cyclic hydrocarbon having 20 or less carbon atoms.

-(Y-O)- in the formula (1) is an arrangement of one kind of structure defined by the formula (4) or a random arrangement of at least two kinds of structures defined by the formula (4). In the formula (4), R₁₇ and R₁₈ may be the same or different and represent a halogen atom, an alkyl group having 6 or less carbon atoms or a phenyl group and R₁₉ and R₂₀ may be the same or different and represent a hydrogen atom, a halogen atom, an alkyl group having 6 or less carbon atoms or a phenyl group.

Z in the formula (1) is an organic group having at least one carbon atom and may contain an oxygen atom, a nitrogen atom, a sulfur atom and/or a halogen atom. Each of a and b is an integer of 0 to 30, provided that at least one of a and b is not 0. Each of c and d is 0 or 1.

In the above formulae, R₁, R₂, R₃, R₇, R₈, R₉, R₁₀, R₁₅ and R₁₆ preferably represent an alkyl group having 3 or less carbon atoms, R₄, R₅, R₆, R₁₁, R₁₂, R₁₃ and R₁₄ preferably represent a hydrogen atom or an alkyl group having 3 or less carbon atoms, R₁₇ and R₁₈ preferably represent an alkyl group having 3 or less carbon atoms, and R₁₉ and R₂₀ preferably represent a hydrogen atom or an alkyl group having 3 or less carbon atoms. When the molecular weight of the compound of the formula (1) is too small, electric characteristics oriented in the phenylene ether structure can not be obtained. When it is too large, the reactivity decreases when the compound of the formula (1) is converted into the polyester. For these reasons, the number average molecular weight of the compound of the formula (1) is preferably 500 to 3,000.

The process for producing the bifunctional phenylene ether oligomer of the formula (1) is not specially limited and it may be produced by any method. For example, the bifunctional phenylene ether oligomer can be producedby oxidatively coupling a bivalent phenol compound and a monovalent phenol compound in the presence of copper and an amine according to the method disclosed in JP-A-2003-12796, Japanese patent application No. 2002-279389 or Japanese patent application No. 2002-018508, to obtain a compound of the formula (10), and optionally introducing - (Z-O-) - into the compound of the formula (10) as required. 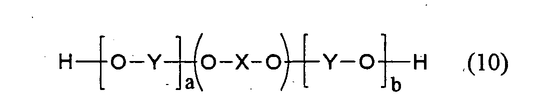 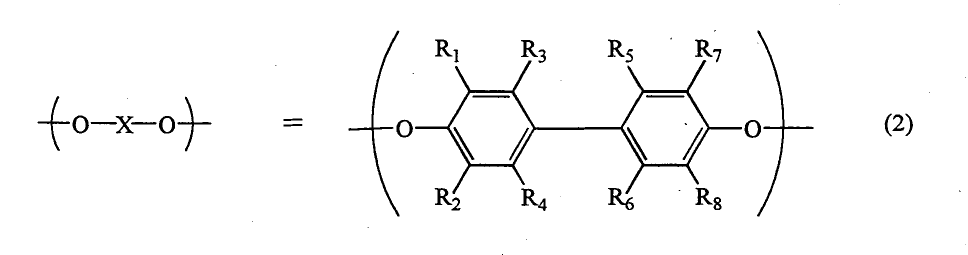 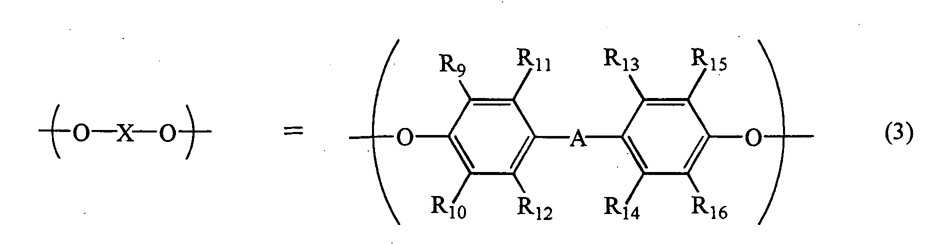 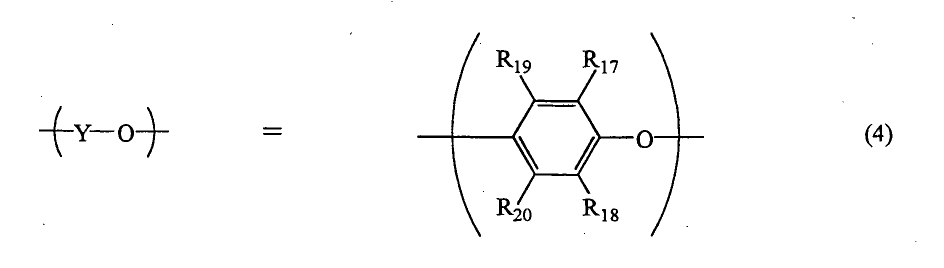 (wherein - (O-X-O) - is represented by the formula (2)
in which R₁, R₂, R₃, R₇ and R₈ may be the same or different and represent a halogen atom, an alkyl group having 6 or less carbon atoms or a phenyl group and R₄, R₅ and R₆ may be the same or different and represent a hydrogen atom, a halogen atom, an alkyl group having 6 or less carbon atoms or a phenyl group
or the formula (3)
in which R₉, R₁₀, R₁₅ and R₁₆ may be the same or different and represent a halogen atom, an alkyl group having 6 or less carbon atoms or a phenyl group and R₁₁, R₁₂, R₁₃ and R₁₄ may be the same or different and represent a hydrogen atom, a halogen atom, an alkyl group having 6 or less carbon atoms or a phenyl group,
A is a linear, branched or cyclic hydrocarbon having 20 or less carbon atoms,
- (Y-O)- is an arrangement of one kind of structure defined by the formula (4) or a random arrangement of at least two kinds of structures defined by the formula (4)
in which R₁₇ and R₁₈ may be the same or different and represent a halogen atom, an alkyl group having 6 or less carbon atoms or a phenyl group and R₁₉ and R₂₀ may be the same or different and represent a hydrogen atom, a halogen atom, an alkyl group having 6 or less carbon atoms or a phenyl group,
and, each of a and b is an integer of 0 to 30, provided that at least one of a and b is not 0).

At Z, an organic group having at least one carbon atom (which may contain an oxygen atom, a nitrogen atom, a sulfur atom and/or a halogen atom) can be placed. Examples of - (Z-O-)-include - ((CH₂)ᵢ-O)-, - (CH₂CHRO)ⱼ-, - (CH₂-Ar-O) -, etc., while it is not limited these examples. i is preferably a numerical value of from 1 to 8, more preferably from 2 to 6, and j is preferably a numerical value of from 1 to 6, more preferably from 1 to 3. A method of adding is typically a method in which - (Z-O-) - is directly added to the intermediate of the formula (10) or a method in which a halide is used, while it is not specially limited to these methods.

A case of introducing, for example, -(CH₂)ᵢO- or - (CH₂CHR₂₁O)ⱼ- as - (Z-O-) - will be explained. -(CH₂)ᵢO- is introduced by reacting a compound of the formula (10) with a halogenated alcohol of the formula (11) in a proper solvent such as alcohol, ether or ketone in the presence of an alkali catalyst such as KOH, K₂CO₃ or NaOEt. - (CH₂CHR₂₁O) ⱼ- is introduced by reacting a compound of the formula (10) with an alkylene oxide of the formula (12) in an aromatic hydrocarbon solvent such as benzene, toluene or xylene in the presence of an alkali catalyst such as KOH, NaOEt or triethylamine according to, for example, the method described in JP-B-52-4547.

E(̵CH₂)̵ᵢOH (11)

wherein E represents Cl or Br and i is an integer of at least 2. 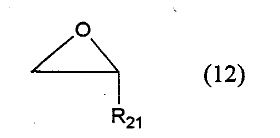 wherein R21 represents a hydrogen atom, a methyl group or an ethyl group.

Then, the polyester of the present invention will be explained. In the polyester of the present invention which has a structure of the formula (5), B represents a bivalent organic group. The organic group of B refers to a group obtained by removing two carboxyl groups from an organic dicarboxylic acid. B is formed of one kind of structure or at least two kinds of structures.

Examples of the organic group of B include bivalent saturated hydrocarbon groups such as a methylene group, an ethylene group, a propylene group, a tetramethylene group, a pentamethylene group, a hexamethylene group, a 1,3-cyclopentylene group and a 1,4-cyclohexylene group, and bivalent aromatic groups such as a m-phenylene group, a p-phenylene group, a 4, 4'-biphenylene group, a 1,4-naphthylene group, a 1,5-naphthylene group, a 1,6-naphthylene group, a 1,7-naphthylene group, a 2,5-naphthylene group and a 2, 6-naphthylene group. The above organic group is not specially limited to these examples.

For producing the polyester of the present invention, a dihydroxy compound other than the compound of the formula (1) can be used as a raw material in combination with the compound of the formula (1), as required. The organic dihydroxy compound other than the compound of the formula (1) is formed of one kind of structure or at least two kinds of structures. When the ratio of the bifunctional oligomer phenylene ether of the formula (1) decreases, it becomes difficult to obtain dielectric characteristics derived from the phenylene ether structure, so that the amount of the organic dihydroxy compound other than the compound of the formula (1) is preferably as follows. The ratio (m/(m+n)) between the mole number (m) of the compound of the formula (1) and the mole number (n) of the organic dihydroxy compound is preferably 0.3 to 1, more preferably 0.5 to 1.

Examples of the organic dihydroxy compound include hydroquinone, resorcinol, catechol, bisphenol A, bisphenol F, bisphenol M, bisphenol Z, bisphenol P, tetramethylbisphenol A, tetramethylbisphenol F, biphenol, tetramethylbiphenol, hexamethylbiphenol, ethylene glycol and butane diol. The organic dihydroxy compound is not specially limited to these examples.

The process for producing the polyester of the present invention is not specially limited. The polyester of the present invention may be produced by any process. For example, it can be obtained by condensing a compound of the formula (1) and a bivalent organic carboxylic acid or its lower alkyl ester in the presence of a condensation catalyst. In this process, for increasing the polymerization degree, there can be used a method of removing a volatile component which is a byproduct, such as water or a lower alcohol, by reducing the pressure in a reactor to a vacuum pressure under heat. In this case, the reaction temperature of the condensation reaction is 150 to 350°C and the vacuum degree is 0.05 to 50 mmHg. The lower alkyl ester includes methyl ester, ethyl ester, etc. Examples of the condensation catalyst include oxides, halides, acetates and oxalates of calcium, manganese, zinc, cadmium, titanium, tin, lead, antimony, etc., and alkoxy compounds.

In another process, the polyester of the present invention can be obtained by respectively dissolving a compound of the formula (1) and a bivalent organic carboxylic acid dichloride into two kinds of solvents which are not dissolved in each other, and then mixing and stirring the thus-obtained two solutions in the presence of an alkali to condensate them at their interface. The solvents used in this process include a combination of a halogenated hydrocarbon solvent such as methylene chloride, chloroform, carbon tetrachloride, 1,2-dichloroethane or 1,1,2-trichloroethane with water, and a combination of an aromatic hydrocarbon solvent such as benzene or toluene with water. The alkali to be presented includes hydroxides of an alkali metal or an alkali earth metal such as sodium hydroxide, potassium hydroxide or barium hydroxide. The reaction temperature is -30 to 60 °C.

In further another process, the polyester of the present invention can be obtained by condensing a compound of the formula (1) and a bivalent organic carboxylic acid dichloride in an organic solvent in the presence of an amine, or the like, as a deoxidizing agent. The organic solvent includes halogen-containing compounds such as methylene chloride, chloroform, carbon tetrachloride, 1,2-dichloroethane, 1,1,2-trichloroethane and 1,2-dichlorobenzene and polar solvents such as N,N-dimethylformamide, N,N-dimethylacetamide, N-methylpyrrolidone, dimethylsulfoxide, sulfolan and nitrobenzene. The deoxidizing agent includes amine compounds such as triethylamine, tributylamine and triethanolamine, pyridine and 2,6-dimethylpyridine, etc.

The molecular weight of the polyester of the present invention changes depending upon the amount ratio of the compound of the formula (1) and dicarboxylic acid or dicarboxylic acid derivative. In view of characteristics as a material, the polyester of the present invention preferably has a weight average molecular weight of at least 10,000. When the weight average molecular weight is less than 10,000, a decrease in mechanical strength, etc., occurs in some cases.

Then, the resin composition of the present invention will be explained. The above resin composition is characterized in that it contains the above-described polyester of the present invention. The resin composition may be combined with a known thermoplastic resin, a thermosetting and/or photocurable resin, etc.

Examples of the thermoplastic resin include polyolefines such as polyethylene, polypropylene and polystyrene, polyesters such as polyethylene terephthalate, polyethylene naphthalate, liquid crystalline polyester and polyarylate, polyamides such as Nylon 6, Nylon 6, 6 andMX Nylon, polyimide and polyamideimide, etc. These thermoplastic resins may be used alone or in combination.

Examples of the thermosetting and/or photocurable resin include an epoxy resin, a cyanate resin, a polyfunctional vinyl compound, an oxetane resin, a (meth)acrylate resin and an epoxy (meth) acrylate resin, etc. These thermosetting and/or photocurable resins may be used alone or in combination. When the thermosetting resin is used, a curing agent or a curing accelerator may be used as required.

Then, the film of the present invention will be explained. The film made of the polyester of the present invention or the resin composition containing the polyester of the present invention can be produced by a known process. For example, the film can be obtained by purifying the polyester of the present invention as required, dissolving the polyester in a solvent to prepare a solution and then volatilizing and removing the solvent by a known solvent cast method or the like. Otherwise, when the polyester of the present invention is meltable, the film can be obtained by a known melt-extrusion method or the like.

The films obtained by the above processes usually have a thickness of 1 to 1,000 µm, and the film may be used singly or a plurality of the films may be laminated and molded under heat and under pressure to form a laminate having a desired thickness.

Then, the laminate which has ametal foil on one surface or each surface of the film of the present invention, provided by the present invention, will be explained. The laminate provided by the present invention can be produced by a known process. For example, the laminate which has a metal foil on one surface can be obtained by a method in which a solution of the polyester of the present invention is applied to a metal foil and a solvent is volatized and removed, a method in which the polyester of the present invention and a metal foil are thermocompression-bonded with a press machine, or a method in which a metal foil is bonded to one surface of the film of the present invention with an adhesive. The laminate which has a metal foil on each surface can be obtained by a method in which the laminate having a metal foil on one surface and a metal foil are thermocompression-bondedwith apress machine, amethod in which metal foils are disposed on both surfaces of the film of the present invention, one metal foil on one surface, and the metal foils and the film are thermocompression-bonded with a press machine, or a method in which metal foils are bonded to both surfaces of the film of the present invention with an adhesive.

### Effect of the Invention

The polyester of the present invention has a low dielectric constant, a low dielectric loss tangent and a low moisture absorptivity so that it is remarkably useful as a high functional polymer material. It can be used, as a material excellent in electric characteristics andmoldability, for wide applications such as an electrical insulating material, a molding material, a resin for a copper-clad laminate, a resin for a resist, a sealing resin for electronic parts, a resin for a color filter of liquid crystal, a coating composition, various coating agents, an adhesive, abuildup laminate material, a resin for a flexible substrate, a functional film, a fiber, a thermoplastic resin modifier and a thermosetting resin modifier.

### Examples

The present invention will be explained more concretely with reference to Examples hereinafter, while the present invention shall not be specially limited to these Examples. Number average molecular weights and weight average molecular weights were measured according to the gel permeation chromatography (GPC) method (calculated as polystyrene). Tetrahydrofuran (THF) was used as a developing solvent for GPC.

### (Synthesis of Bifunctional phenylene ether oligomer)

### (Synthesis Example 1)

A longitudinally long reactor having a volume of 100 liters and equipped with a stirrer, a thermometer, an air-introducing tube and baffleplates was charged with 4.61 g (20.8 mmol) of CuBr₂, 9 g (52 mmol) of N,N'-di-t-butylethylenediamine, 333.8 g (3.3 mol) of n-butyldimethylamine and 26 kg of toluene. The components were stirred at a reaction temperature of 40 °C. A mixed solution (molar ratio of a bivalent phenol of the formula (2) : amonovalent phenol of the formula (4) = 1:5) was obtained by dissolving 1.29 kg (4.8 mol) of 2,21,3,3',5,51-hexamethyl-(1,1'-biphenyl)-4,41-diol (to be referred to as "HMBP" hereinafter), 2.02 kg (24 mol) of 2,6-dimethylphenol, 6 g (35 mmol) of N,N'-di-t-butylethylenediamine and 129.8 g (1.28 mol) of n-butyldimethylamine in 23 kg of methanol in advance. The mixed solution was dropwise added to the mixture in the reactor over 230 minutes while carrying out bubbling with 5. 2L/min of a mixed gas of nitrogen and air which gas had an oxygen concentration of 8 %, and stirring was carried out. After the completion of the addition, 1.5 kg of water in which 236 g (623 mmol) of tetrasodium ethylenediamine tetraacetate was dissolved was added to the stirred mixture to terminate the reaction. An aqueous layer and an organic layer were separated. Then, the organic layer was washed with 1.0N hydrochloric acid aqueous solution and then washed with pure water. The thus-obtained solution was concentrated by an evaporator and then dried under a reduced pressure, to obtain 2.95 kg of a resin a represented by the formula (1). The resin a had a number average molecular weight of 957, a weight average molecular weight of 1,539 and a hydroxyl group equivalent of 440.

### (Synthesis Example 2)

A longitudinally long reactor having a volume of 12 liters and equipped with a stirrer, a thermometer, an air-introducing tube and baffleplates was charged with 6.64 g (29.9 mmol) of CuBr₂, 1.29 g (7.5 mmol) of N,N'-di-t-butylethylenediamine, 48.07 g (475.9 mmol) of n-butyldimethylamine and 2,600 g of toluene. The components were stirred at a reaction temperature of 40 °C. Amixed solution (molar ratio of a bivalent phenol of the formula (2) : a monovalent phenol of the formula (4) = 1:10) was obtained by dissolving 129.32 g (0.48 mol) of HMBP, 584.38 g (4.79 mol) of 2,6-dimethylphenol, 0.87 g (5.1 mmol) of N,N'-di-t-butylethylenediamine and 18.69 g (185.1 mmol) of n-butyldimethylamine in 2,300 g of methanol in advance. The mixed solution was dropwise added to the mixture in the reactor over 230 minutes while carrying out bubbling with 5.2L/min of a mixed gas of nitrogen and air which gas had an oxygen concentration of 8 %, and stirring was carried out. After the completion of the addition, 1,500 g of water in which 34.09 g (89.7 mmol) of tetrasodium ethylenediamine tetraacetate was dissolved was added to the stirred mixture to terminate the reaction. An aqueous layer and an organic layer were separated. Then, the organic layer was washed with 1.0N hydrochloric acid aqueous solution and then washed with pure water. The thus-obtained solution was concentrated by an evaporator and then dried under a reduced pressure, to obtain 702.2 g of a resin b represented by the formula (1). The resin b had a number average molecular weight of 1,490, a weight average molecular weight of 2,320 and a hydroxyl group equivalent of 750.

### (Synthesis Example 3)

A longitudinally long reactor having a volume of 12 liters and equipped with a stirrer, a thermometer, an air-introducing tube and baffleplates was charged with 9.36 g (42.1 mmol) of CuBr₂, 1.81 g (10.5 mmol) of N,N'-di-t-butylethylenediamine, 67.77 g (671.0 mmol) of n-butyldimethylamine and 2,600 g of toluene. The components were stirred at a reaction temperature of 40 °C. A mixed solution (molar ratio of a bivalent phenol of the formula (2) : a monovalent phenol of the formula (4) = 1:15) was obtained by dissolving 129.32 g (0.48 mol) of HMBP, 878.4 g (7.2 mol) of 2,6-dimethylphenol, 1.22 g (7.2 mmol) of N,N'-di-t-butylethylenediamine and 26.35 g (260.9 mmol) of n-butyldimethylamine in 2,300 g of methanol in advance. The mixed solution was dropwise added to the mixture in the reactor over 230 minutes while carrying out bubbling with 5.2L/min of a mixed gas of nitrogen and air which gas had an oxygen concentration of 8 %, and stirring was carried out. After the completion of the addition, 1,500 g of water in which 48.06 g (126.4 mmol) of tetrasodium ethylenediamine tetraacetate was dissolved was added to the stirred mixture to terminate the reaction. An aqueous layer and an organic layer were separated. Then, the organic layer was washed with 1.0N hydrochloric acid aqueous solution and then washed with pure water. The thus-obtained solution was concentrated by an evaporator and then dried under a reduced pressure, to obtain 990.1 g of a resin c represented by the formula (1).The resin c had a number average molecular weight of 1, 975, a weight average molecular weight of 3,514 and a hydroxyl group equivalent of 990.

### (Synthesis Example 4)

A longitudinally long reactor having a volume of 20 liters and equipped with a stirrer, a thermometer, an air-introducing tube and baffleplates was charged with 13 g (0.12 mol) of CuCl, 707 g (5.5 mol) of di-n-butylamine and 4, 000 g of methyl ethyl ketone. The components were stirred at a reaction temperature of 40 °C. A solution (molar ratio of a bivalent phenol of the formula (3) : a monovalent phenol of the formula (4) = 1:5) was obtained by dissolving 410 g (1.6 mol) of 4, 4'-methylenebis (2, 6-dimethylphenol) and 977 g (8 mol) of 2, 6-dimethylphenol in 8, 000 g of methyl ethyl ketone in advance. The solution was dropwise added to the mixture in the reactor over 120 minutes while carrying out bubbling with 2L/min of air. After the completion of the addition, further, stirring was carried out for 60 minutes with continuing the bubbling with 2L/min of air. A disodium dihydrogen ethylenediamine tetraacetate aqueous solution was added to the stirred mixture to terminate the reaction. Then, washing was carried out with 1M hydrochloric acid aqueous solution three times and then washing was carried out with ion-exchanged water. The thus-obtained solution was concentrated by an evaporator and then dried under a reduced pressure, to obtain 1,102 g of a resin d represented by the formula (1). The resin d had a number average molecular weight of 1, 023, a weight average molecular weight of 1,647 and a hydroxyl group equivalent of 445.

### (Synthesis Example 5)

### (Introduction of Z part)

A reactor equipped with a stirrer, a thermometer and a reflux tube was charged with 300 g (hydroxyl group 0.68 mol) of the resin a, 93.9 g (0.68 mol) of potassium carbonate and 2,500 ml of acetone. These components were refluxed under nitrogen for 3 hours. Then, 113.4 g (0.81 mol) of 3-bromo-1-propanol was dropwise added over 1 hour. After the completion of the addition, further, reflux was carried out for 30 hours. Neutralization was carried out with hydrochloric acid, then a large amount of ion-exchanged water was added to obtain a precipitate, and toluene was added to carry out extraction. The thus-obtained solution was concentrated by an evaporator and then dropwise added to methanol to obtain a pricipitate. A solid was recovered by filtration, and the recovered solid was dried under a reduced pressure to obtain 256 g of a resin e represented by the formula (1). The resin e had a number aver age molecular weight of 1,314, a weight average molecular weight of 1,708 and a hydroxyl group equivalent of 513.

### (Synthesis of polyester)

### (Example 1)

A 3-liter reactor equipped with a stirrer, a thermometer and a dropping funnel was charged with 100 g (hydroxyl group 0.23 mol) of the resin a, 23.0 g (0.23 mol) of triethylamine and 900 g of 1,2-dichloroethane and the mixture was cooled down to 0°C by ice bath. 23.1 g (0.11 mol) of isophthaloyl chloride and 200 g of 1,2-dichloroethane in the dropping funnel were dropwise added under nitrogen over 40 minutes. After the completion of the addition, stirring was carried out for 3 hours. The stirred mixture was diluted with 1,200 g of 1, 2-dichloroethane and then the diluted mixture was dropwise added to 6 liters of methanol, to precipitate a solid. The solid was recovered by filtration. The recovered solid was dispersed in pure water and then stirred with a mixer for 1 hour to wash the solid. The solid dispersed in the pure water was separated by filtration and dried under a reduced pressure to obtain 101 g of a resin f. The resin f had a number average molecular weight of 11, 300 and a weight average molecular weight of 43, 800. The structure of the polymer was confirmed by a nuclear magnetic resonance spectrum and an infrared spectroscopic spectrum.

### (Example 2)

A 3-liter reactor equipped with a stirrer, a thermometer and a dropping funnel was charged with 100 g (hydroxyl group 0.23 mol) of the resin a, 23.0 g (0.23 mol) of triethylamine and 900 gof 1, 2-dichloroethane, andthemixture was cooled down to 0°C by ice bath. 23.1 g (0.11-mol) of terephthaloyl chloride and 200 g of 1, 2-dichloroethane in the dropping funnel were dropwise added under nitrogen over 40 minutes. After the completion of the addition, stirring was carried out for 3 hours. The stirred mixture was diluted with 1,200 g of 1, 2-dichloroethane and then the diluted mixture was dropwise added to 6 liters of methanol, to precipitate a solid. The solid was recovered by filtration. The recovered solid was dispersed in pure water and then stirred with a mixer for 1 hour to wash the solid. The solid dispersed in the pure water was separated by filtration and dried under a reduced pressure to obtain 99 g of a resin g. The resin g had a number average molecular weight of 11, 600 and a weight average molecular weight of 46, 800. The structure of the polymer was confirmed by a nuclear magnetic resonance spectrum and an infrared spectroscopic spectrum.

### (Example 3)

A 3-liter reactor equipped with a stirrer, a thermometer and a dropping funnel was charged with 100 g (hydroxyl group 0.23 mol) of the resin a, 23.0 g (0.23 mol) of triethylamine and 900 g of 1, 2-dichloroethane and the mixture was cooled down to 0°C by ice bath. 20.8 g (0.11 mol) of adipoyl chloride and 200 g of 1, 2-dichloroethane in the dropping funnel were dropwise added under nitrogen over 40 minutes. After the completion of the addition, stirring was carried out for 3 hours. The stirred mixture was diluted with 1,200 g of 1,2-dichloroethane and then the diluted mixture was dropwise added to 6 liters of methanol, to precipitate a solid. The solid was recovered by filtration. The recovered solid was dispersed in pure water and then stirred with a mixer for 1 hour to wash the solid. The solid dispersed in the pure water was separated by filtration and dried under a reduced pressure to obtain 103 g of a resin h. The resin h had a number average molecular weight of 16, 800 and a weight average molecular weight of 58, 800. The structure of the polymer was confirmed by a nuclear magnetic resonance spectrum and an infrared spectroscopic spectrum.

### (Example 4)

A 3-liter reactor equipped with a stirrer, a thermometer and a dropping funnel was charged with 100 g (hydroxyl group 0.13 mol) of the resin b, 13.4 g (0.13 mol) of triethylamine and 900 g of 1, 2-dichloroethane and the mixture was cooled down to 0°C by ice bath. 13.5g (66 mmol) of isophthaloyl chloride and 150 g of 1, 2-dichloroethane in the dropping funnel were dropwise added under nitrogen over 40 minutes. After the completion of the addition, stirring was carried out for 3 hours. The stirred mixture was diluted with 1,200 g of 1,2-dichloroethane and then the diluted mixture was dropwise added to 6 liters of methanol, to precipitate a solid. The solid was recovered by filtration. The recovered solid was dispersed in pure water and then stirred with a mixer for 1 hour to wash the solid. The solid dispersed in the pure water was separated by filtration and dried under a reduced pressure to obtain 95 g of a resin i. The resin i had a number average molecular weight of 10,500 and a weight average molecular weight of 38,600. The structure of the polymer was confirmed by a nuclear magnetic resonance spectrum and an infrared spectroscopic spectrum.

### (Example 5)

A 3-liter reactor equipped with a stirrer, a thermometer and a dropping funnel was charged with 100 g (hydroxyl group 0.10 mol) of the resin c, 10.2 g (0.10 mol) of triethylamine and 900 g of 1, 2-dichloroethane and the mixture was cooled down to 0°C by ice bath. 10. 3 g (51 mmol) of isophthaloyl chloride and 100 g of 1, 2-dichloroethane in the dropping funnel were dropwise added under nitrogen over 40 minutes. After the completion of the addition, stirring was carried out for 3 hours. The stirred mixture was diluted with 1,200 g of 1,2-dichloroethane and then the diluted mixture was dropwise added to 6 liters of methanol, to precipitate a solid. The solid was recovered by filtration. The recovered solid was dispersed in pure water and then stirred with a mixer for 1 hour to wash the solid. The solid dispersed in the pure water was separated by filtration and dried under a reduced pressure to obtain 96 g of a resin j . The resin j had a number average molecular weight of 11, 600 and a weight average molecular weight of 39,100. The structure of the polymer was confirmed by a nuclear magnetic resonance spectrum and an infrared spectroscopic spectrum.

### (Example 6)

A 3-liter reactor equipped with a stirrer, a thermometer and a dropping funnel was charged with 100 g (hydroxyl group 0.22 mol) of the resin d, 22.7 g (0.22 mol) of triethylamine and 900 g of 1, 2-dichloroethane and the mixture was cooled down to 0°C by ice bath. 22.8 g (0.11 mol) of isophthaloyl chloride and 200 g of 1,2-dichloroethane in the dropping funnel were dropwise added under nitrogen over 40 minutes. After the completion of the addition, stirring was carried out for 3 hours. The stirred mixture was diluted with 1,200 g of 1, 2-dichloroethane and then the diluted mixture was dropwise added to 6 liters of methanol, to precipitate a solid. The solid was recovered by filtration. The recovered solid was dispersed in pure water and then stirred with a mixer for 1 hour to wash the solid. The solid dispersed in the pure water was separated by filtration and dried under a reduced pressure to obtain 105 g of a resin k. The resin k had a number average molecular weight of 10, 800 and a weight average molecular weight of 40, 100. The structure of the polymer was confirmedby a nuclear magnetic resonance spectrum and an infrared spectroscopic spectrum.

### (Example 7)

A 3-liter reactor equipped with a stirrer, a thermometer and a dropping funnel was charged with 100 g (hydroxyl group 0.19 mol) of the resin e, 19.7 g (0.19 mol) of triethylamine and 900 g of 1, 2-dichloroethane and the mixture was cooled down to 0°C by ice bath. 19.8g (97 mmol) of isophthaloyl chloride and 200 g of 1, 2-dichloroethane in the dropping funnel were dropwise added under nitrogen over 40 minutes. After the completion of the addition, stirring was carried out for 3 hours. The stirred mixture was diluted with 1,200 g of 1,2-dichloroethane and then the diluted mixture was dropwise added to 6 liters of methanol, to precipitate a solid. The solid was recovered by filtration. The recovered solid was dispersed in pure water and then stirred with a mixer for 1 hour to wash the solid. The solid dispersed in the pure water was separated by filtration and dried under a reduced pressure to obtain 107 g of a resin 1. The resin 1 had a number average molecular weight of 11, 200 and a weight average molecular weight of 43, 600. The structure of the polymer was confirmed by a nuclear magnetic resonance spectrum and an infrared spectroscopic spectrum.

### (Example 8)

A 3-liter reactor equipped with a stirrer, a thermometer and a dropping funnel was charged with 100 g (hydroxyl group 0.23 mol) of the resin a, 23.0 g (0.23 mol) of triethylamine and 900 g of 1, 2-dichloroethane and the mixture was cooled down to 0°C by ice bath. 11.6 g (56 mmol) of terephthaloyl chloride, 11.6g (56 mmol) of isophthaloyl chloride and 200 g of 1, 2-dichloroethane in the dropping funnel were dropwise added under nitrogen over 40 minutes. After the completion of the addition, stirring was carried out for 3 hours. The stirred mixture was diluted with 1,200 g of 1,2-dichloroethane and then the diluted mixture was dropwise added to 6 liters of methanol, to precipitate a solid. The solid was recovered by filtration. The recovered solid was dispersed in pure water and then stirred with a mixer for 1 hour to wash the solid. The solid dispersed in the pure water was separated by filtration and dried under a reduced pressure to obtain 107 g of a resin m. The resin m had a number average molecular weight of 12, 900 and a weight average molecular weight of 55, 100. The structure of the polymer was confirmed by a nuclear magnetic resonance spectrum and an infrared spectroscopic spectrum.

### (Example 9)

A 1-liter reactor equipped with a stirrer, a thermometer and a dropping funnel was charged with 50 g (hydroxyl group 0.11 mol) of the resin a, 30.7 g (hydroxyl group 0.11 mol) of HMBP, 23.0 g (0.23 mol) of triethylamine and 720 g of 1,2-dichloroethane and the mixture was cooled down to 0°C by ice bath. 23.1 g (0.11 mol) of isophthaloyl chloride and 200 g of 1,2-dichloroethane in the dropping funnel were dropwise added under nitrogen over 40 minutes. After the completion of the addition, stirring was carried out for 3 hours. The stirred mixture was diluted with 1, 200 g of 1, 2-dichloroethane and then the diluted mixture was dropwise added to 6 liters of methanol, to precipitate a solid. The solid was recovered by filtration. The recovered solid was dispersed in pure water and then stirred with a mixer for 1 hour to wash the solid. The solid dispersed in the pure water was separated by filtration and dried under a reduced pressure to obtain 95 g of a resin n. The resin n had a number average molecular weight of 13,300 and a weight average molecular weight of 60,100. The structure of the polymer was confirmed by a nuclear magnetic resonance spectrum and an infrared spectroscopic spectrum.

### (Example 10)

A 1-liter reactor equipped with a stirrer, a thermometer and a dropping funnel was charged with 50 g (hydroxyl group 0.11 mol) of the resin a, 25.9 g (hydroxyl group 0.11 mol) of bisphenol A, 23.0 g (0.23 mol) of triethylamine and 720 g of 1,2-dichloroethane and the mixture was cooled down to 0°C by ice bath. 23.1 g (0.11 mol) of isophthaloyl chloride and 200 g of 1,2-dichloroethane in the dropping funnel were dropwise added under nitrogen over 40 minutes. After the completion of the addition, stirring was carried out for 3 hours. The stirred mixture was diluted with 1,200 g of 1,2-dichloroethane and then the diluted mixture was dropwise added to 6 liters of methanol, to precipitate a solid. The solid was recovered by filtration. The recovered solid was dispersed in pure water and then stirred with a mixer for 1 hour to wash the solid. The solid dispersed in the pure water was separated by filtration and dried under a reduced pressure to obtain 90 g of a resin o. The resin o had a number average molecular weight of 15,500 and a weight average molecular weight of 64, 000. The structure of the polymer was confirmed by a nuclear magnetic resonance spectrum and an infrared spectroscopic spectrum.

### (Example 11)

A 3-liter reactor equipped with a stirrer, a thermometer and a dropping funnel was chargedwith 50 g (hydroxyl group 0.11 mol) of the resin a, 50.5 g (hydroxyl group 0.11 mol) of the resin d, 23.0 g (0.23 mol) of triethylamine and 900 g of 1,2-dichloroethane and the mixture was cooled down to 0°C by ice bath. 23.1 g (0.11 mol) of isophthaloyl chloride and 200 g of 1,2-dichloroethane in the dropping funnel were dropwise added under nitrogen over 40 minutes. After the completion of the addition, stirring was carried out for 3 hours. The stirred mixture was diluted with 1,200 g of 1,2-dichloroethane and then the diluted mixture was dropwise added to 6 liters of methanol, to precipitate a solid. The solid was recovered by filtration. The recovered solid was dispersed in pure water and then stirred with a mixer for 1 hour to wash the solid. The solid dispersed in the pure water was separated by filtration and dried under a reduced pressure to obtain 110 g of a resin p. The resin p had a number average molecular weight of 11, 500 and a weight average molecular weight of 47, 300. The structure of the polymer was confirmed by a nuclear magnetic resonance spectrum and an infrared spectroscopic spectrum.

### (Comparative Example 1)

A 2-liter reactor equipped with a stirrer, a thermometer and a dropping funnel was charged with 50 g (hydroxyl group 0.37 mol) of HMBP, 37.4 g (0.37 mol) of triethylamine and 450 g of 1, 2-dichloroethane and the mixture was cooled down to 0°C by ice bath. 37.6 g (0.19 mol) of isophthaloyl chloride and 400 g of 1,2-dichloroethane in the dropping funnel were dropwise added under nitrogen over 40 minutes. After the completion of the addition, stirring was carried out for 3 hours. The stirred mixture was diluted with 1, 000 g of 1,2-dichloroethane and then the diluted mixture was dropwise added to 5 liters of methanol, to precipitate a solid. The solid was recovered by filtration. The recovered solid was dispersed in pure water and then stirred with a mixer for 1 hour to wash the solid. The solid dispersed in the pure water was separated by filtration and dried under a reduced pressure to obtain 71 g of a resin q. The resin q had a number average molecular weight of 25, 400 and a weight average molecular weight of 85, 000. The structure of the polymer was confirmed by a nuclear magnetic resonance spectrum and an infrared spectroscopic spectrum.

### (Comparative Example 2)

A 2-liter reactor equipped with a stirrer, a thermometer and a dropping funnel was chargedwith 50 g (hydroxyl group 0.44 mol) ofbisphenolA, 44.3g (0.44mol) of triethylamine and 450 g of 1, 2-dichloroethane and the mixture was cooled down to 0°C by ice bath. 44.5 g (0.22 mol) of isophthaloyl chloride and 400 g of 1,2-dichloroethane in the dropping funnel were dropwise added under nitrogen over 40 minutes. After the completion of the addition, stirring was carried out for 3 hours. The stirred mixture was diluted with 1,000 g of 1,2-dichloroethane and then the diluted mixture was dropwise added to 5 liters of methanol, to precipitate a solid. The solid was recovered by filtration. The recovered solid was dispersed in pure water and then stirred with a mixer for 1 hour to wash the solid. The solid dispersed in the pure water was separated by filtration and dried under a reduced pressure to obtain 78 g of a resin r. The structure of the polymer was confirmed by an infrared spectroscopic spectrum. The resin r was insoluble in THF so that calculation of a molecular weight could not be carried out by a GPC measurement. The resin r was insoluble in heavy chloroform so that it was impossible to carry out a structure analysis by NMR.

10 g of one of the resins obtained in Examples 1 to 11 and Comparative Examples 1 and 2 and 90 g of an organic solvent were mixed and stirred for checking whether the resin was soluble or insoluble. Table 1 shows results.
O : Soluble, × : Insoluble

**Table 1**

| | 1,2-dichloroethane | Tetrahydrofuran |
|---|---|---|
| Example 1 | O | O |
| Example 2 | O | O |
| Example 3 | O | O |
| Example 4 | O | O |
| Example 5 | O | O |
| Example 6 | O | O |
| Example 7 | O | O |
| Example 8 | O | O |
| Example 9 | O | O |
| Example 10 | O | O |
| Example 11 | O | O |
| Comparative Example 1 | O | O |
| Comparative Example 2 | × | × |

### (Example 12)

20 g of one of the resins obtained in Examples 1 to 11 was dissolved in 80 g of 1,2-dichloroethane to obtain a solution, the solutionwas appliedto an 18 µm-thick electrolytic copper foil with a barcoater, and the solvent was removed by drying under a reduced pressure, whereby a laminate having a copper foil on one surface was obtained. The laminate had a polyester layer having a thickness of 25 µm.

### (Example 13)

An 18 µm-thick electrolytic copper foil was placed on the polyester surface of the laminate obtained in Example 12 and the resultant set was laminate-molded with a vacuum heating press at 250 °C under 20 MPa, to obtain a laminate having copper foils on both surfaces.

### (Example 14)

The copper foil of the laminate obtained in Example 12 was removed by etching, to obtain a polyester film having a thickness of 25 µm.

20 g of one of the resins obtained in Example 1 to 11 and Comparative Example 1 was dissolved in 80 g of 1,2-dichloroethane, to obtain a solution. Procedures of applying the solution to an 18 µm-thick electrolytic copper foil with a barcoater and volatilizing the solvent were repeated to obtain a polyester layer having a thickness of 0.5 mm. Then, the copper was removed by etching to obtain a plate specimen. The specimen was evaluated for various properties by the following methods. Table 2 shows results.
Dielectric constant and dielectric loss tangent: Measured according to a cavity resonant oscillation method.
Moisture absorptivity: The specimen was immersed in 80°C-hot water for 24 hours and then it was measured for moisture absorptivity.

**Table 2**

| | Dielectric constant (10 GHz) | Dielectric loss tangent (10 GHz) | Moisture absorptivity (%) |
|---|---|---|---|
| Example 1 | 2.67 | 0.0049 | 0.90 |
| Example 2 | 2.70 | 0.0048 | 0.91 |
| Example 3 | 2.65 | 0.0044 | 0.85 |
| Example 4 | 2.68 | 0.0044 | 0.76 |
| Example 5 | 2.66 | 0.0045 | 0.69 |
| Example 6 | 2.68 | 0.0046 | 0.92 |
| Example 7 | 2.69 | 0.0045 | 0.81 |
| Example 8 | 2.71 | 0.0049 | 0.88 |
| Example 9 | 2.73 | 0.0055 | 0.97 |
| Example 10 | 2.72 | 0.0059 | 0.98 |
| Example 11 | 2.69 | 0.0049 | 0.88 |
| Comparative Example 1 | 2.90 | 0.0078 | 1.80 |

### (Example 15)

10 g of one of the resins obtained in Examples 1 to 11 and 10 g of polystyrene (weight average molecular weight 10,000) were dissolved in 80 g of toluene to obtain a solution, the solution was applied to an 18 µm-thick electrolytic copper foil with a barcoater, and the solvent was removed by drying under a reduced pressure, to obtain a laminate having a copper foil on one surface. Then, the copper was removed by etching to obtain a film. The film had a thickness of 25 µm.
Typically, the polyester of the invention has a weight average molecular weight of up to 150,000, more typically up to 100,000, preferably up to 80,000 and more preferably up to 65,000.

## Claims

1. A polyester having a structure of the formula (5) 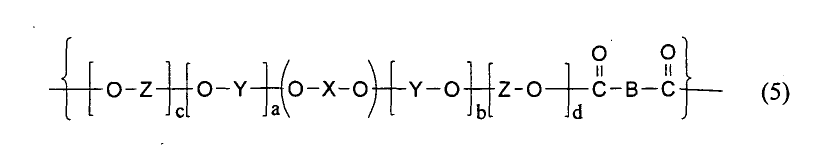 which is obtainable from a bifunctional phenylene ether oligomer having a number average molecular weight of 500 to 3,000 and having the formula (1), 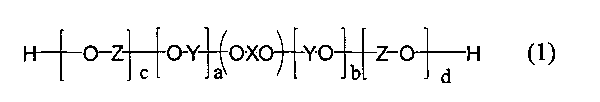 wherein:
- -(O-X-O)- represents at least one moiety of the formula (2) and/or the formula (3);
- A is a linear, branched or cyclic hydrocarbon having 20 or less carbon atoms;
- -(Y-O)- is a moiety of the formula (4) or a random arrangement of at least two kinds of moieties of the formula (4);
- Z is an organic group having at least one carbon atom and optionally an oxygen atom, a nitrogen atom, a sulfur atom and/or a halogen atom;
- B is a bivalent organic group and is formed of one kind of structure or at least two kinds of structures;
- each of a and b is an integer of 0 to 30, provided that at least one of a and b is not 0; and
- each of c and d is 0 or 1,
the formulae (2), (3) and (4) being, 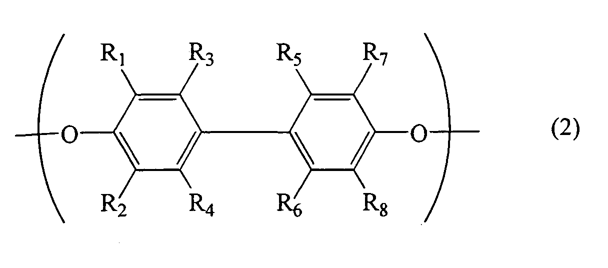 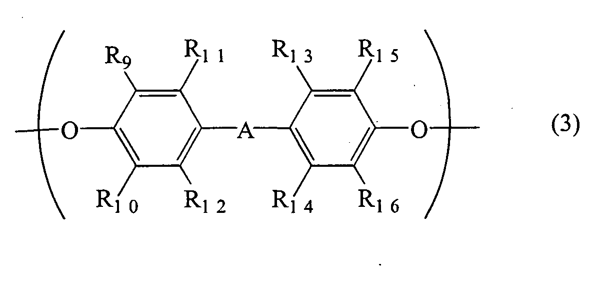 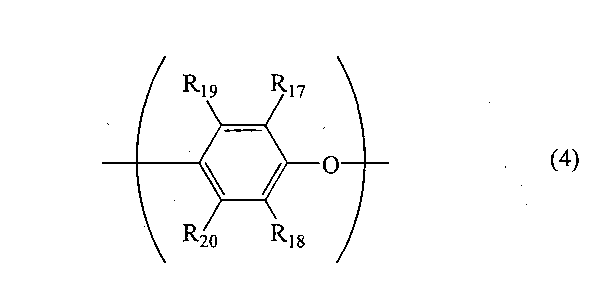
wherein:
- R₁, R₂, R₃, R₇ and R₈ may be the same or different and represent a halogen atom, an alkyl group having 6 or less carbon atoms or a phenyl group and R₄, R₅ and R₆ may be the same or different and represent a hydrogen atom, a halogen atom, an alkyl group having 6 or less carbon atoms or a phenyl group;
- R₉, R₁₀, R₁₅ and R₁₆ may be the same or different and represent a halogen atom, an alkyl group having 6 or less carbon atoms or a phenyl group and R₁₁, R₁₂, R₁₃ and R₁₄ may be the same or different and represent a hydrogen atom, a halogen atom, an alkyl group having 6 or less carbon atoms or a phenyl group;
- R₁₇ and R₁₈ may be the same or different and represent a halogen atom, an alkyl group having 6 or less carbon atoms or a phenyl group and R₁₉ and R₂₀ may be the same or different and represent a hydrogen atom, a halogen atom, an alkyl group having 6 or less carbon atoms or a phenyl group

2. A polyester according to claim 1, wherein -(O-X-O)- is a moiety of the formula (6) or the formula (7) and -(Y-O)- is a moiety of the formula (8) or the formula (9) or a random arrangement of moieties of the formula (8) and the formula (9), 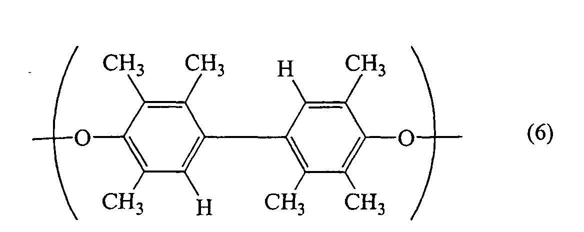 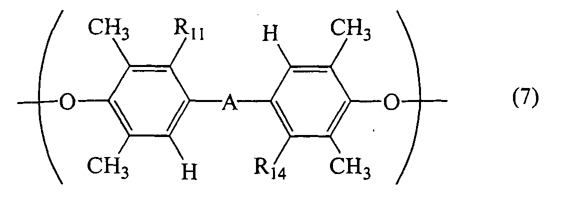 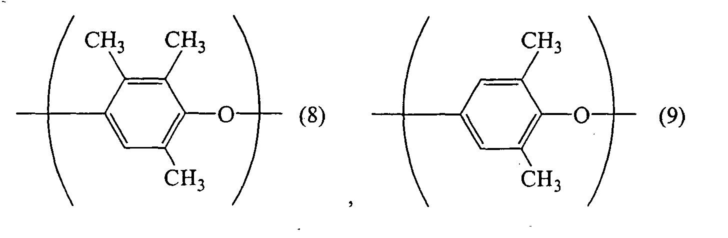 wherein R₁₁ and R₁₄ are the same or different and each represent a hydrogen atom or a methyl group and A is a linear, branched or cyclic hydrocarbon having 20 or less carbon atoms.

3. A polyester according to claim 2, wherein -(Y-0)- is a moiety of the formula (9).

4. A polyester according to any one of the preceding claims, which has a weight average molecular weight of at least 10,000.

5. A polyester according to any one of the preceding claims, wherein -[Z-O]- represents -[(CH₂)ᵢ-O]ⱼ -, - [(CH₂-CHR₂₁)ᵢ-O]ⱼ - or -[(CH₂-Ar)ᵢ-O]ⱼ-, wherein i is from 1 to 8, j is from 1 to 6, each R₂₁ is the same or different and represents hydrogen, methyl or ethyl and Ar represents a C₆-C₁₀ aryl group.

6. A polyester according to any one of the preceding claims, wherein B represents a bivalent saturated hydrocarbon group or a bivalent aromatic group.

7. A polyester according to claim 6, wherein the bivalent saturated hydrocarbon group is a C₁-C₈ alkylene group or a C₃-C₆ cycloalkyl group and/or the bivalent aromatic group is a bivalent phenyl or naphthyl group.

8. A resin composition containing a polyester according to any one of claims 1 to 7.

9. A film made of a polyester according to any one of claims 1 to 6, or a resin composition according to claim 9.

10. A laminate comprising a film according to claim 9 and metal foil(s) laminated on one surface or both surfaces of the film.
